# EUROPÄISCHE PATENTANMELDUNG

(11) **EP 4 836 306 A1**
(43) Veröffentlichungstag der Anmeldung: **04.11.2026**
(21) Anmeldenummer: 26168838.6
(22) Anmeldetag: 30.03.2026
(51) Int. Cl.: H04B 3/54

(54) **KOMMUNIKATIONSVERFAHREN UND KOMMUNIKATIONSVORRICHTUNG ZUR NACHRICHTENÜBERTRAGUNG FÜR EIN IT-STROMVERSORGUNGSSYSTEM**

(30) Priorität: 29.04.2025 DE 102025116504
(71) Anmelder: Bender GmbH & Co. KG, 35305 Grünberg (DE)
(72) Erfinder: Burmeister, Jens, 01159 Dresden (DE); Wünsch, Hendrik, 01108 Dresden (DE)
(74) Vertreter: advotec.

(57) **Zusammenfassung**

Die Erfindung betrifft ein Kommunikationsverfahren und eine Kommunikationsvorrichtung für ein IT-Stromversorgungssystem (2) zur Nachrichtenübertragung zwischen einem ersten Betriebsmittel (10) mit einem ersten Stromsensor (12) zur Erfassung eines in dem IT-Stromversorgungssystem (2) fließenden Fehlerstroms (IF, I_{Fmod}) und einem zweiten Betriebsmittel (20) mit einem zweiten Stromsensor (22) zur Erfassung des Fehlerstroms (IF, I_{Fmod}), wobei das erste Betriebsmittel (10) zwischen einen aktiven Leiter des IT-Stromversorgungssystems (2) und Erdpotenzial (PE) angeschlossen ist und die Nachrichtenübertragung durch eine Modulation des Fehlerstroms (IF, I_{Fmod}) erfolgt. Die Erfindung ermöglicht die Kommunikation zwischen zwei Betriebsmitteln in einem IT-Netz, ohne dass diese Betriebsmittel über ihre messtechnische Anbindung hinaus explizite kabelgebundene oder drahtlose Kommunikationsschnittstellen aufweisen müssen. Die Kommunikation findet ausschließlich über die den Fehlerstrom erfassenden, ohnehin zur Aufnahme von Messwerten vorhandenen Schnittstellen statt.

## Beschreibung

Die Erfindung betrifft ein Kommunikationsverfahren sowie eine Kommunikationsvorrichtung zur Nachrichtenübertragung für ein IT-Stromversorgungssystem, mit einem ersten Betriebsmittel mit einem ersten Stromsensor zur Erfassung eines in dem IT-Stromversorgungssystem fließenden Fehlerstroms und einem zweiten Betriebsmittel mit einem zweiten Stromsensor zur Erfassung des Fehlerstroms, wobei das erste Betriebsmittel zwischen einen aktiven Leiter des IT-Stromversorgungssystems und Erdpotenzial angeschlossen ist.

Bei erhöhten Anforderungen an die Betriebs-, Brand- und Berührungssicherheit elektrischer Anlagen kommt die Netzform eines ungeerdeten Stromversorgungssystems zum Einsatz, die auch als isoliertes Netz (frz. "Isolé Terre"-IT) oder als IT-Stromversorgungssystem bezeichnet wird. Bei dieser Art des Stromversorgungssystems sind die aktiven Teile (aktive Leiter des IT-Netzes) von dem Erdpotenzial - gegen Erde - getrennt. Die Körper der angeschlossenen elektrischen Verbraucher sind einzeln oder gemeinsam über einen Schutzleiter auf das Erdpotenzial gelegt. Der Vorteil dieser IT-Netze liegt darin, dass bei einem Isolationsfehler die Funktion der angeschlossenen elektrischen Verbraucher nicht beeinträchtigt wird, da sich wegen des im Idealfall unendlich großen Isolationswiderstandswertes zwischen einem aktiven Leiter des IT-Netzes und Erde kein geschlossener Stromkreis ausbilden kann. Das IT-Netz kann also auch bei einem ersten Isolationsfehler weiter betrieben werden.

In dem IT-Netz können oder - wie im Falle eines Isolationsüberwachungsgerätes in Verbindung mit einem Isolationsfehlersuchsystem, müssen - Betriebsmittel (Messgeräte) dauerhaft oder temporär installiert sein. Damit diese Messgeräte miteinander kommunizieren können, ist ein geeignetes Kommunikationsverfahren zum Austausch von Nachrichten erforderlich. Die Übertragung einer Nachricht setzt geeignete Kommunikationsschnittstellen an den Betriebsmitteln voraus.

Allerdings sind die technischen Voraussetzungen für eine kabelgebundene oder drahtlose Kommunikationsschnittstelle an den jeweils miteinander kommunizierenden Betriebsmitteln oftmals nicht gegeben. Zwar verfügen normativ vorgeschriebene stationäre Isolationsüberwachungsgeräte typischerweise über einen externen Kommunikationskanal (z.B. das Modbus-Protokoll), um mit der Außenwelt (Intranet/Internet) kommunizieren zu können, jedoch bestehen aus Kostengründen und sicherheitstechnischen Aspekten oftmals Einschränkungen hinsichtlich der Kommunikation innerhalb der in dem IT-Netz angeschlossenen Betriebsmittel. Insbesondere bei mobilen Betriebsmitteln wie beispielsweise portablen Isolationsfehlersuchgeräten sind kabelgebundene Ankopplungen in das IT-Netz beispielsweise über Modbus, UART oder CAN-Bus problematisch, da diese Geräte typischerweise keine direkte Kommunikationsschnittstelle aufweisen.

Hinzu kommen in bestimmten Betriebsumgebungen erhöhte Anforderungen an das Gerätegehäuse hinsichtlich der Dichtigkeit und der elektrischen Sicherheit. Eine zusätzliche leitungsgebundene Schnittstelle bedeutet immer eine zusätzliche Gehäuseöffnung, welche zu vermeiden ist, da z.B. Reinigungs- oder Desinfektionsmittel eindringen könnten. Zusätzlich erwächst aus diesen Anforderungen die Schwierigkeit, dass Geräte durch Einwegschrauben nicht ohne weiteres geöffnet werden können, um beispielsweise eine Programmierschnittstelle oder einen Diagnosestecker anzuschließen.

Auch ist die elektrische Schaltung in einem (portablen) Gerät in der Regel nicht galvanisch von dem Stromversorgungssystem getrennt, da eine zusätzliche kabelgebundene Kommunikationsschnittstelle mit galvanischer Trennung das Gerät wiederum aufwändiger gestalten und damit verteuern würde.

Auch drahtlose Schnittstellen zur Nachrichtenübertragung, z.B. mittels WLAN, Bluetooth oder Zigbee weisen über den Kostenaspekt hinaus nachteilige technische Wirkungen auf, da sie in abgesicherten Betriebsumgebungen wie beispielsweise in bestimmten Krankenhausbereichen aufgrund ihrer möglichen elektromagnetischen Wechselwirkung die Funktion elektrischer medizinischer Geräte stören können.

Der vorliegenden Erfindung liegt somit die Aufgabe zugrunde, ein Verfahren sowie eine dieses Verfahren umsetzende Vorrichtung zu konzipieren, welche eine technisch zuverlässige und kosteneffiziente Nachrichtenübertragung zwischen zwei beliebigen in einem IT-Stromversorgungssystem angeschlossenen Betriebsmitteln ermöglicht.

Diese Aufgabe wird in Verbindung mit den Merkmalen des Oberbegriffs in Anspruch 1 dadurch gelöst, dass die Nachrichtenübertragung durch eine Modulation des Fehlerstroms erfolgt.

Ausgangspunkt der Betrachtungen ist das erste Betriebsmittel, über dessen ersten Stromsensor mindestens eine elektrisch leitende Verbindung zwischen jeweils einem der aktiven Leiter des IT-Stromversorgungssystems und dem Erdpotenzial hergestellt ist. Das erste Betriebsmittel kann beispielsweise ein normativ vorgeschriebenes, dauerhaft installiertes Isolationsüberwachungsgerät sein.

Die grundlegende Idee der Erfindung beruht nun darauf, einen in einem der aktiven Leiter des IT-Netzes fließenden, erzwungenen Fehlerstrom zur Nachrichtenübertragung zu nutzen. Die Nachrichtenübertragung erfolgt dabei zwischen dem ersten Betriebsmittel, welches den ersten Stromsensor zur Erfassung des in dem IT-Stromversorgungssystem fließenden Fehlerstrom aufweist, und dem weiteren in dem IT-Netz angeschlossenen zweiten Betriebsmittel mit dem zweiten Stromsensor.

Die aktiven Leiter des IT-Netzes, an die das erste und zweite Betriebsmittel zu messtechnischen Zwecken - beispielsweise in Form einer Messgerätekombination aus Isolationsüberwachungsgerät und Isolationsfehlersuchgerät - angeschlossen sind, stellen somit den physischen (gegenständlichen) Nachrichtenübertragungskanal bereit, sodass keine expliziten Kommunikationsschnittstellen für eine kabelgebundene oder drahtlose Nachrichtenübertragung zwischen den Betriebsmitteln erforderlich sind. Ein entsprechend der zu übermittelnden Nachricht modulierter Fehlerstrom stellt dabei das informationstragende Signal als physikalische Größe dar.

Die Erfindung ermöglicht die Kommunikation zwischen zwei Betriebsmitteln in einem IT-Netz, ohne dass diese Betriebsmittel über ihre messtechnische Anbindung hinaus explizite kabelgebundene oder drahtlose Kommunikationsschnittstellen aufweisen müssen. Die Kommunikation findet ausschließlich über die den Fehlerstrom erfassenden, ohnehin zur Aufnahme von Messwerten vorhandenen Schnittstellen statt.

In weiterer Ausgestaltung umfasst das Kommunikationsverfahren die Verfahrensschritte: Herstellen einer temporären Erdankopplung zwischen einem der aktiven Leiter des IT-Stromversorgungssystems und dem Erdpotenzial mittels einer Erdankopplungs-Schalteinrichtung an dem zweiten Betriebsmittel zum Erzwingen des Fehlerstroms, Erfassen des Fehlerstroms in dem ersten Betriebsmittel mittels des ersten Stromsensors, Modulieren des Fehlerstroms durch das erste Betriebsmittel zum Übermitteln einer Nachricht an das zweite Betriebsmittel, Erfassen des modulierten Fehlerstroms in dem zweiten Betriebsmittel mittels des zweiten Stromsensors, Demodulieren des modulierten Fehlerstroms in dem zweiten Betriebsmittel, Lösen der temporären Erdankopplung mittels der Erdankopplungs-Schalteinrichtung und Auswerten der Nachricht in dem zweiten Betriebsmittel.

Zunächst wird mittels einer Erdankopplungs-Schalteinrichtung an dem zweiten Betriebsmittel für die Dauer der Nachrichtenübertragung eine temporäre Erdankopplung zwischen einem der aktiven Leiter des IT-Stromversorgungssystems und dem Erdpotenzial hergestellt. Diese Erdankopplung an das Erdpotenzial muss nicht zwingend ein satter Erdschluss mit dem Schutzleiter sein, sondern kann auch als ohmsche Kopplung in Form einer strombegrenzenden hochohmigen Kopplung oder in Wechselspannungsnetzen als kapazitive Kopplung vorgenommen werden.

Infolge der Erdankopplung wird zunächst ein unmodulierter Fehlerstrom erzwungen. Dieser fließt über den angekoppelten aktiven Leiter, über die als provozierter Isolationsfehler (Erdankopplung) wirkende Erdankopplungs-Schalteinrichtung und über den Schutzleiter (Erde) in das erste Betriebsmittel zurück. Dort wird der unmodulierte Fehlerstrom von dem ersten Stromsensor, welcher den Fehlerstromkreis schließt, erfasst.

Der von dem zweiten Betriebsmittel veranlasste, noch unmodulierte Fehlerstrom wird in dem ersten Betriebsmittel entsprechend der zu übermittelnden Nachricht moduliert und somit zu einem modulierten Fehlerstrom. Das erste Betriebsmittel kann somit innerhalb des IT-Netzes als eine Nachrichtenquelle zum Übermitteln der von außen über die externe Anbindung des ersten Betriebsmittels eingebrachte Nachricht an das zweite Betriebsmittel aufgefasst werden.

Das zweite Betriebsmittel wirkt als Nachrichtensenke und erfasst den modulierten Fehlerstrom mittels des zweiten Stromsensors. Zur Informationsrückgewinnung wird der modulierte Fehlerstrom demoduliert, die Nachricht ausgewertet und die temporäre Erdankopplung mittels der Erdankopplungs-Schalteinrichtung abschließend gelöst.

Mit Vorteil erfolgt die Nachrichtenübertragung zwischen einem Isolationsüberwachungsgerät als erstem Betriebsmittel und einem Isolationsfehlersuchgerät als zweitem Betriebsmittel.

Da IT-Stromversorgungssysteme mit normgemäßen Isolationsüberwachungsgeräten ausgestattet sein müssen, ist es von besonderem Vorteil, wenn als erstes Betriebsmittel ein derartiges Isolationsüberwachungsgerät und als zweites Betriebsmittel ein (portables) Isolationsfehlersuchgerät zur Lokalisierung eines Isolationsfehlers eingesetzt wird. In dieser Messgerätekombination ist es dann möglich, beispielsweise Konfigurationsdaten von dem an die Außenwelt angebundenen Isolationsüberwachungsgerät ohne weitere interne Kommunikationsschnittstellen an das Isolationsfehlersuchgerät zu übertragen.

Weiter erfolgt das Erfassen des Fehlerstroms in dem Isolationsüberwachungsgerät mit einem Vorwiderstand als erstem Stromsensor und in dem Isolationsfehlersuchgerät mit einem Messstromwandler als zweitem Stromsensor.

Im Fall der Verwendung eines Isolationsüberwachungsgerätes als erstes Betriebsmittel und eines Isolationsfehlersuchgerätes als zweites Betriebsmittel ist der erste Stromsensor als strombegrenzender Vorwiderstand ausgebildet, an dem ein durch den Fehlerstrom verursachter Spannungsabfall und damit der Fehlerstrom selbst erkannt wird. Der zweite Stromsensor in dem zweiten Betriebsmittel ist vorzugsweise als Messstromwandler zur Erfassung des modulierten Fehlerstroms ausgebildet.

Vorzugsweise erfolgt das Modulieren des Fehlerstroms mittels Amplitudenmodulation.

Die zu übertragende Information ist bei dieser Modulationsart in dem Amplitudenverlauf des Fehlerstroms enthalten, wobei die Modulation in digitaler Form wert- und zeitdiskret mit vorzugsweise rechteckförmigen Impulsen (binäre oder mehrstufige Amplitudentastung) erfolgt.

Weiterhin erfolgt eine Kanalcodierung der Nachricht.

Als Schutz gegen Übertragungsfehler in dem Fehlerstromkreis kann der Nachricht Zusatzinformation in Form einer fehlerkorrigierenden oder fehlererkennenden Codierung hinzugefügt werden.

Die in der erfindungsgemäßen Kommunikationsvorrichtung als strukturelle Merkmale beanspruchten funktionalen Einheiten wie die Stromsensoren, die Erdankopplungs-Schalteinrichtung, der Modulator/Demodulator und die Auswerteeinheit führen die entsprechenden Verfahrensschritte des erfindungsgemäßen Verfahrens aus. Somit treffen die mit dem Verfahren erzielten technischen Wirkungen und die daraus resultierenden Vorteile gleichermaßen auch auf die Kommunikationsvorrichtung zu.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1**:: ein Übersichts-Blockschaltbild der erfindungsgemäßen Kommunikationsvorrichtung für ein IT-Stromversorgungssystem,
- **Fig. 2**:: ein funktionales Blockschaltbild des ersten und zweiten Betriebsmittels in dem IT-Stromversorgungssystem und
- **Fig. 3**:: ein Ablaufdiagramm des erfindungsgemäßen Kommunikationsverfahrens.

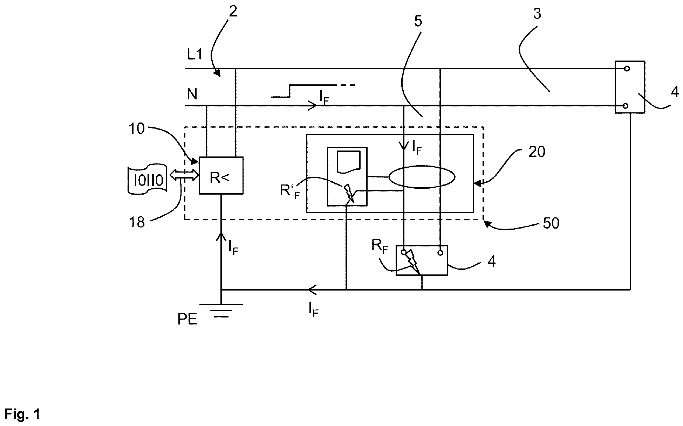

**Fig. 1** zeigt ein Übersichts-Blockschaltbild der erfindungsgemäßen Kommunikationsvorrichtung 50 für ein IT-Stromversorgungssystem 2.

Die erfindungsgemäße Kommunikationsvorrichtung 50 besteht aus einem ersten Betriebsmittel 10 und einem zweiten Betriebsmittel 20, welche jeweils mit mindesten einem der aktiven Leiter L1, N des IT-Stromversorgungssystems 2 und dem Schutzleiter PE (Erdpotenzial) verbunden werden können.

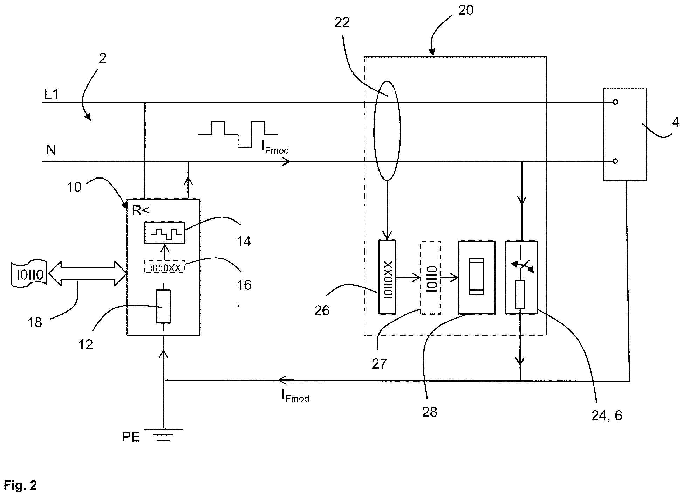

An das IT-Stromversorgungssystem 2 ist in dem Hauptsystem 3 und in dem Subsystem 5 jeweils eine über den Schutzleiter PE geerdete Last 4 angeschlossen. Zur Veranschaulichung eines Fehlerstromkreises ist ein tatsächlicher Isolationsfehler R_{F} an der Last 4 des Subsystems 5 zwischen dem aktiven Leiter (hier dem Neutralleiter) N und dem Schutzleiter PE angenommenen. Der Isolationsfehler R_{F} bewirkt den Fehlerstrom I_{F}, der sowohl in dem ersten Betriebsmittel 10 durch den ersten Stromsensor 12 (Fig. 2) als auch in dem zweiten Betriebsmittel 20 durch den zweiten Stromsensor 22 (Fig. 2) erkannt wird.

Zur Anwendung des erfindungsgemäßen Kommunikationsverfahrens 40 wird ein provozierter Isolationsfehler R'_{F} in Form der temporären Erdankopplung 6 (Fig. 2) an dem zweiten Betriebsmittel 20 ausgelöst.

Das erste Betriebsmittel 10 besitzt einen Kommunikationskanal 18 zu einem Außenbereich, beispielsweise zu einer übergeordneten Steuerung, über die Konfigurationsparameter oder Steuerungsinformationen an die in dem IT-Stromversorgungssystem 2 angeschlossenen Betriebsmittel 10, 20 übertragen werden können.

Beispielhaft ist das erste Betriebsmittel 10 als Isolationsüberwachungsgerät ausgeführt. Grundsätzlich kann das erste Betriebsmittel 10 beliebig ausgeführt sein, sofern es als Voraussetzung einen ersten Stromsensor 12 aufweist, über den das erste Betriebsmittel 10 mit dem Erdpotenzial PE verbunden ist, um im (Isolations-)Fehlerfall den Fehlerstromkreis zu schließen und den darin fließenden Fehlerstrom I_{F} zu erkennen.

In **Fig. 2** ist ein funktionales Blockschaltbild der in dem IT-Stromversorgungssystem 2 angeschlossenen ersten und zweiten Betriebsmittel 10, 20 dargestellt. Die Darstellung zeigt die Kommunikation in dem Zustand, in dem - nach dem Erzeugen und der Erfassung des erzwungenen Fehlerstroms I_{F} - der dargestellte modulierte Fehlerstrom I_{Fmod} als nachrichtentragendes Signal erzeugt wird.

Das erste Betriebsmittel 10 (Isolationsüberwachungsgerät) umfasst den ersten Stromsensor 12 zum Erfassen des von der Erdankopplungs-Schalteinrichtung 24 des zweiten Betriebsmittels 20 (Isolationsfehlersuchgerät) erzwungenen Fehlerstroms I_{F} sowie einen Modulator 14, der vorzugsweise als Amplituden-Modulator ausgeführt ist. Der Modulator 14 formt aus dem erzwungenen Fehlerstrom I_{F} den modulierten Fehlerstrom I_{Fmod}. Daneben kann das erste Betriebsmittel 10 optional einen Kanalcodierer 16 aufweisen, um Übertragungsfehler zu erkennen oder zu korrigieren.

Ein Demodulator 26 in dem zweiten Betriebsmittel 20 demoduliert den modulierten Fehlerstrom I_{Fmod} und leitet die demodulierte Nachricht gegebenenfalls nach einer Kanaldecodierung 27 an eine Auswerteeinheit 28 weiter.

Das zweite Betriebsmittel 20 ist beispielhaft als Isolationsfehlersuchgerät ausgeführt, welches zur Lokalisierung eines zuvor von dem Isolationsüberwachungsgerät erkannten tatsächlichen Isolationsfehlers R_{F} (Fig. 1) in dem IT-Stromversorgungssystem installiert ist. Auch das zweite Betriebsmittel 20 ist als beliebiges (Mess-)Gerät ausführbar, sofern es als Voraussetzung einen zweiten Stromsensor 22 zur Erkennung der Fehlerströme I_{F}, I_{Fmod} aufweist.

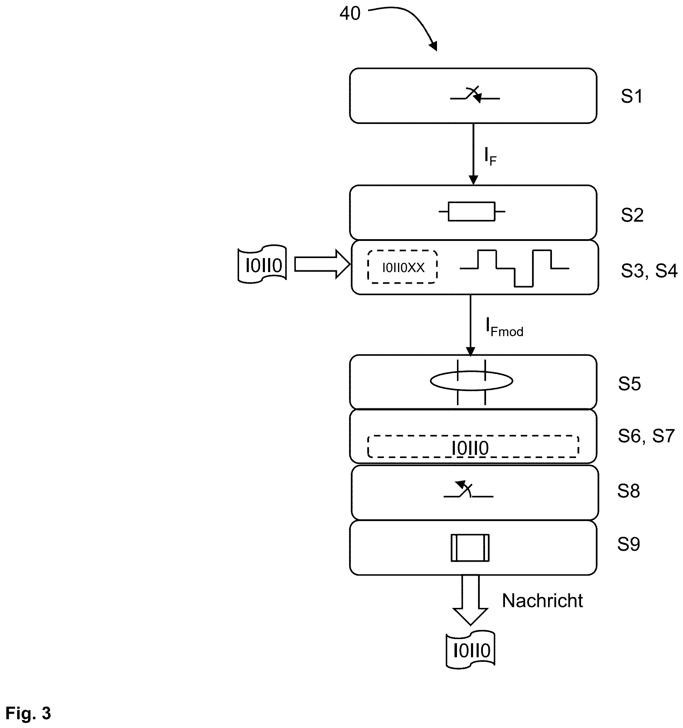

**Fig. 3** zeigt ein Ablaufdiagramm des erfindungsgemäßen Kommunikationsverfahrens 40.

Davon ausgehend, dass das erste Betriebsmittel 10 über den ersten Stromsensor 12 eine Verbindung zwischen einem der aktiven Leiter L1, N hergestellt hat, wird in Schritt S1 in dem zweiten Betriebsmittel 20 mittels der Erdankopplungs-Schalteinrichtung 24 eine temporäre, für die Dauer der Nachrichtenübertragung bestehende Verbindung (temporäre Erdankopplung 6) zu dem Schutzleiter PE hergestellt, sodass ein Stromkreis entsteht, in dem der Fehlerstrom I_{F} fließen kann.

Der Fehlerstrom I_{F} sollte eine hinreichend große Amplitude aufweisen, um diesen von simultan auftretenden tatsächlichen Fehlerströmen unterscheiden zu können. Eine Amplitude von mehreren mA, beispielsweise 3mA, erscheint geeignet. Fortschrittlichere, über eine Binärübertragung hinausgehende Modulationsverfahren können in Verbindung mit einer Kanalcodierung auch geringere Fehlerstromamplituden in der Größenordnung von unter einem mA zulassen.

Der Fehlerstrom I_{F} wird in Schritt S2 von dem ersten Stromsensor 12 des ersten Betriebsmittels 10 erfasst und in Schritt S4 entsprechend der zu übertragenden Nachricht moduliert, wobei sich der modulierte Fehlerstrom I_{Fmod} ergibt. Optional ist eine Kanalcodierung S3 zur störresistenten Nachrichtenübertragung der Modulation S4 vorgeschaltet.

Der modulierte Fehlerstrom I_{Fmod} wird von dem zweiten Stromsensor 22 in dem zweiten Betriebsmittel 20 in Schritt S5 erfasst, in Schritt S6 demoduliert und gegebenenfalls in Schritt S7 kanaldecodiert. Anschließend kann in Schritt S8 die temporäre Erdankopplung 6 mittels der Erdankopplungs-Schalteinrichtung 24 gelöst werden und die Nachricht wird in Schritt S9 ausgewertet, indem beispielsweise Konfigurationsparameter in dem zweiten Betriebsmittel 20 automatisch eingestellt werden.

## Patentansprüche

1. Kommunikationsverfahren (40) für ein IT-Stromversorgungssystem (2) zur Nachrichtenübertragung zwischen einem ersten Betriebsmittel (10) mit einem ersten Stromsensor (12) zur Erfassung eines in dem IT-Stromversorgungssystem (2) fließenden Fehlerstroms (I_{F}, I_{Fmod}) und einem zweiten Betriebsmittel (20) mit einem zweiten Stromsensor (22) zur Erfassung des Fehlerstroms (I_{F}, I_{Fmod}), wobei das erste Betriebsmittel (10) zwischen einen aktiven Leiter des IT-Stromversorgungssystems (2) und Erdpotenzial (PE) angeschlossen ist,
**dadurch gekennzeichnet, dass**
die Nachrichtenübertragung durch eine Modulation des Fehlerstroms (I_{F}, I_{Fmod}) erfolgt.

2. Kommunikationsverfahren (40) nach Anspruch 1,
**gekennzeichnet durch**
Herstellen (S1) einer temporären Erdankopplung (6) zwischen einem der aktiven Leiter des IT-Stromversorgungssystems (2) und dem Erdpotenzial (PE) mittels einer Erdankopplungs-Schalteinrichtung (24) an dem zweiten Betriebsmittel (20) zum Erzwingen des Fehlerstroms (I_{F}),
Erfassen (S2) des Fehlerstroms (I_{F}) in dem ersten Betriebsmittel (10) mittels des ersten Stromsensors (12),
Modulieren (S4) des Fehlerstroms (I_{F}) durch das erste Betriebsmittel (10) zum Übermitteln einer Nachricht an das zweite Betriebsmittel (20),
Erfassen (S5) des modulierten Fehlerstroms (I_{Fmod}) in dem zweiten Betriebsmittel (20) mittels des zweiten Stromsensors (22), Demodulieren (S6) des modulierten Fehlerstroms (I_{Fmod}) in dem zweiten Betriebsmittel (20),
Lösen (S8) der temporären Erdankopplung (6) mittels der Erdankopplungs-Schalteinrichtung (24),
Auswerten (S9) der Nachricht in dem zweiten Betriebsmittel (20).

3. Kommunikationsverfahren (40) nach Anspruch 1 oder 2,
**dadurch gekennzeichnet, dass**
die Nachrichtenübertragung zwischen einem Isolationsüberwachungsgerät als erstem Betriebsmittel (10) und einem Isolationsfehlersuchgerät als zweitem Betriebsmittel (20) erfolgt.

4. Kommunikationsverfahren (40) nach Anspruch 3,
**dadurch gekennzeichnet, dass**
das Erfassen (S2) des Fehlerstroms (I_{F}) in dem Isolationsüberwachungsgerät mit einem Vorwiderstand als erstem Stromsensor (12) und in dem Isolationsfehlersuchgerät mit einem Messstromwandler als zweitem Stromsensor (22) erfolgt.

5. Kommunikationsverfahren (40) nach einem der Ansprüche 2 bis 4,
**dadurch gekennzeichnet, dass**
das Modulieren (S4) des Fehlerstroms (I_{F}) mittels Amplitudenmodulation erfolgt.

6. Kommunikationsverfahren (40) nach einem der Ansprüche 2 bis 5,
**dadurch gekennzeichnet, dass**
eine Kanalcodierung (S3) der Nachricht erfolgt.

7. Kommunikationsvorrichtung (50) zur Nachrichtenübertragung für ein IT-Stromversorgungssystem (2), mit einem ersten Betriebsmittel (10) mit einem ersten Stromsensor (12) zur Erfassung eines in dem IT-Stromversorgungssystem (2) fließenden Fehlerstroms (I_{F}, I_{Fmod}) und mit einem zweiten Betriebsmittel (20) mit einem zweiten Stromsensor (22) zur Erfassung des Fehlerstroms (I_{F}, I_{Fmod}), wobei das erste Betriebsmittel (10) zwischen einen aktiven Leiter des IT-Stromversorgungssystems (2) und Erdpotenzial (PE) angeschlossen ist,
**dadurch gekennzeichnet, dass**
der Fehlerstrom (I_{F}, I_{Fmod}) zur Nachrichtenübertragung moduliert ist.

8. Kommunikationsvorrichtung (50) nach Anspruch 7,
**dadurch gekennzeichnet, dass**
das zweite Betriebsmittel (20) eine Erdankopplungs-Schalteinrichtung (24) aufweist zur Herstellung einer temporären Erdankopplung (6) zwischen einem der aktiven Leiter des IT-Stromversorgungssystems (2) und dem Erdpotenzial (PE), um den Fehlerstrom (I_{F}) zu erzwingen,
das erste Betriebsmittel (10) einen Modulator (14) zur Modulation des Fehlerstroms (I_{F}) aufweist, um eine Nachricht an das zweite Betriebsmittel (20) zu übermitteln,
das zweite Betriebsmittel einen Demodulator (26) zur Demodulation des modulierten Fehlerstroms (I_{Fmod}) aufweist,
das zweite Betriebsmittel (20) eine Auswerteeinheit (28) zur Auswertung der Nachricht aufweist.

9. Kommunikationsvorrichtung (50) nach Anspruch 7 oder 8,
**dadurch gekennzeichnet, dass**
das erste Betriebsmittel (10) ein Isolationsüberwachungsgerät und das zweite Betriebsmittel (20) ein Isolationsfehlersuchgerät ist.

10. Kommunikationsvorrichtung (50) nach Anspruch 9,
**dadurch gekennzeichnet, dass**
der erste Stromsensor (12) als Vorwiderstand ausgebildet ist und der zweite Stromsensor (22) als Messstromwandler ausgebildet ist.

11. Kommunikationsvorrichtung (50) nach einem der Ansprüche 8 bis 10,
**dadurch gekennzeichnet, dass**
der Modulator (14) als Amplituden-Modulator ausgebildet ist und der Demodulator (26) als Amplituden-Demodulator ausgebildet ist.

12. Kommunikationsvorrichtung (50) nach einem der Ansprüche 8 bis 11,
**dadurch gekennzeichnet, dass**
das erste Betriebsmittel (10) einen Kanalcodierer (16) und das zweite Betriebsmittel (20) einen Kanaldecodierer (27) aufweist.
